(19) Europäisches Patentamt / European Patent Office / Office européen des brevets

(11) **EP 4 443 180 A1**

(12) **EUROPEAN PATENT APPLICATION**
published in accordance with Art. 153(4) EPC

(43) Date of publication:
**09.10.2024 Bulletin 2024/41**

(21) Application number: **22901476.6**

(22) Date of filing: **10.05.2022**

(51) International Patent Classification (IPC):
$G01R\ 31/367^{(2019.01)}$    $G01R\ 31/36^{(2020.01)}$
$G01R\ 31/3835^{(2019.01)}$    $G01R\ 31/392^{(2019.01)}$
$G01R\ 31/396^{(2019.01)}$    $G06N\ 3/08^{(2023.01)}$
$G06N\ 3/04^{(2023.01)}$

(52) Cooperative Patent Classification (CPC):
**G01R 31/367; G01R 31/36; G01R 31/3835;
G01R 31/392; G01R 31/396; G06N 3/04;
G06N 3/08;** Y02E 60/10

(86) International application number:
**PCT/KR2022/006616**

(87) International publication number:
**WO 2023/101113 (08.06.2023 Gazette 2023/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.11.2021   KR 20210168032**

(71) Applicant: **Mona Inc.
Gunsan-si, Jeollabuk-do 54158 (KR)**

(72) Inventor: **SONG, Chang Hee
Seoul 08090 (KR)**

(74) Representative: **Studio Torta S.p.A.
Via Viotti, 9
10121 Torino (IT)**

(54) **BATTERY DIAGNOSIS METHOD AND DEVICE THEREFOR**

(57)    A battery diagnosis method and a device therefor are disclosed. The battery diagnosis device configured to generate, by using a profile prediction model, a voltage profile of a predefined section based on a partial voltage waveform generated when charging or discharging a battery, and predict a deterioration state of the battery based on the voltage profile using a state prediction model.

FIG. 6

**Description**

Technical Field

One or more embodiments relate to a battery diagnosis method and a device therefor, and more specifically, to a method of diagnosing a deterioration state of a battery on the basis of a partial voltage waveform and a device therefor.

Background Art

Secondary batteries (hereinafter referred to as 'batteries') may be repeatedly recharged and are used in various fields, such as electric vehicles, energy storage systems (ESS), etc. When the batteries are repeatedly charged and discharged, they need to be replaced after a certain period of time because their charging and discharging capacity deteriorates. The deterioration state of a battery is generally determined by measuring a state of health (SOH). However, in order to measure the SOH of a battery, a process of charging or discharging of the battery must be performed. Therefore, there is a disadvantage in that it takes a long time to measure the SOH.

Disclosure

Technical Problem

One or more embodiments provide a method of accurately diagnosing a deterioration state of a battery on the basis of a partial voltage waveform and a device therefor.

Technical Solution

According to one or more embodiments, a battery diagnosis method includes generating, by using a profile prediction model, a voltage profile of a predefined section based on a partial voltage waveform when charging or discharging a battery, and predicting a deterioration state of the battery based on the voltage profile by using a state prediction model, wherein the profile prediction model is an artificial intelligence model that learned to predict the voltage profile of a predefined section based on a partial voltage waveform, and the state prediction model is a state prediction model that learned to predict the deterioration state of the battery based on the voltage profile.

According to one or more embodiments, a battery diagnosis device includes a profile generation unit configured to generate, by using a generator of a generative adversarial network (GAN) learned to generate a voltage profile in a predefined section, a voltage profile based on a partial voltage waveform generated when charging or discharging a battery; and a prediction unit configured to predict the deterioration state of the battery based on the voltage profile using a state prediction model that learned to predict a battery state.

Advantageous Effects

According to an embodiment of the disclosure, the deterioration state, such as the charging capacity, of a battery may be accurately diagnosed based on a partial voltage waveform showing when charging or discharging the battery, thereby shortening the time required for battery diagnosis. Also, the present embodiment may be effectively applied not only to diagnosing the deterioration state of batteries in use, but also to diagnosing the deterioration state of waste batteries for recycling.

Description of Drawings

FIG. 1 is a block diagram illustrating an example of an overall system structure for battery diagnosis according to an embodiment of the disclosure.

FIG. 2 is a diagram showing an example of a profile prediction model according to an embodiment of the disclosure.

FIG. 3 is a diagram illustrating an example of a state prediction model according to an embodiment of the disclosure.

FIG. 4 is a diagram showing an example of a voltage profile according to an embodiment of the disclosure.

FIG. 5 is a diagram showing an experimental example of a state prediction model according to an embodiment of the disclosure.

FIG. 6 is a flowchart showing an example of a battery diagnosis method according to an embodiment of the disclosure.

FIG. 7 is a diagram showing an example of implementing a profile prediction model using a generative adversarial network (GAN) according to an embodiment of the disclosure.

FIG. 8 is a diagram showing an example of data input to a separator in a GAN according to an embodiment of the disclosure.

FIG. 9 is a diagram showing an example of an experiment for comparing the performance of a generator of a GAN according to an embodiment of the disclosure.

FIG. 10 is a block diagram showing an example configuration of a battery diagnosis device according to an embodiment of the disclosure.

Mode for Invention

Hereinafter, a battery diagnosis method and a device therefor will now be described more fully with reference to the accompanying drawings.

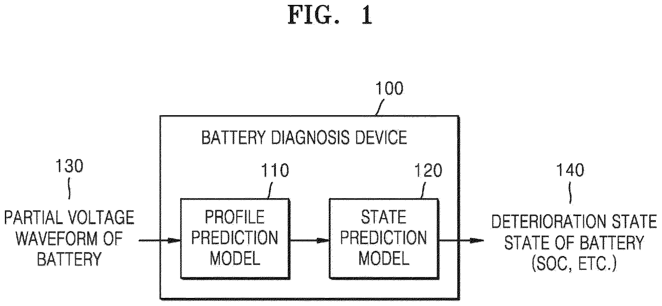

FIG. 1 is a diagram illustrating an example of an overall system structure for battery diagnosis according to an embodiment of the disclosure.

Referring to FIG. 1, a battery diagnosis device 100 includes a profile prediction model 110 and a state prediction model 120. When the battery diagnosis device 100 receives a partial voltage waveform 130 from a battery, the battery diagnosis device 100 generates a voltage waveform (hereinafter referred to as a 'voltage profile') in a predefined certain section using the profile prediction model 110, and identifies a deterioration state 140 (for example, State of Charge (SOC), etc.) of the battery by inputting the 'voltage profile to the state prediction model 120.

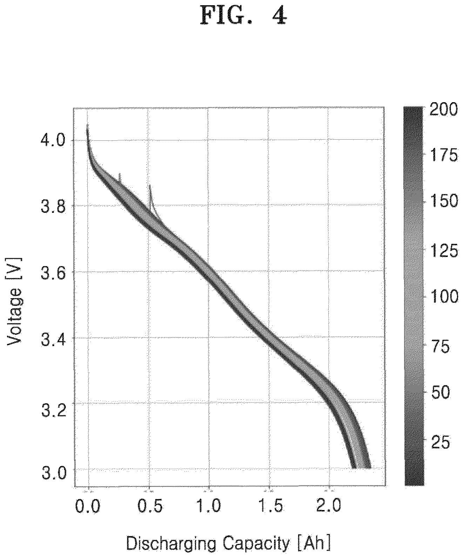

The voltage waveform 130 is information representing the amount of change in voltage obtained by measuring an actual battery over a certain period of time. The voltage waveform 130 may be defined in various forms, and an example of this is shown in FIG. 4. Hereinafter, for convenience of explanation, a partial voltage waveform of the entire voltage waveform of the battery is referred to as 'voltage waveform', and a voltage waveform of a certain section into which the state prediction model is input is referred to as 'voltage profile'. That is, a certain section of the voltage profile is a voltage waveform.

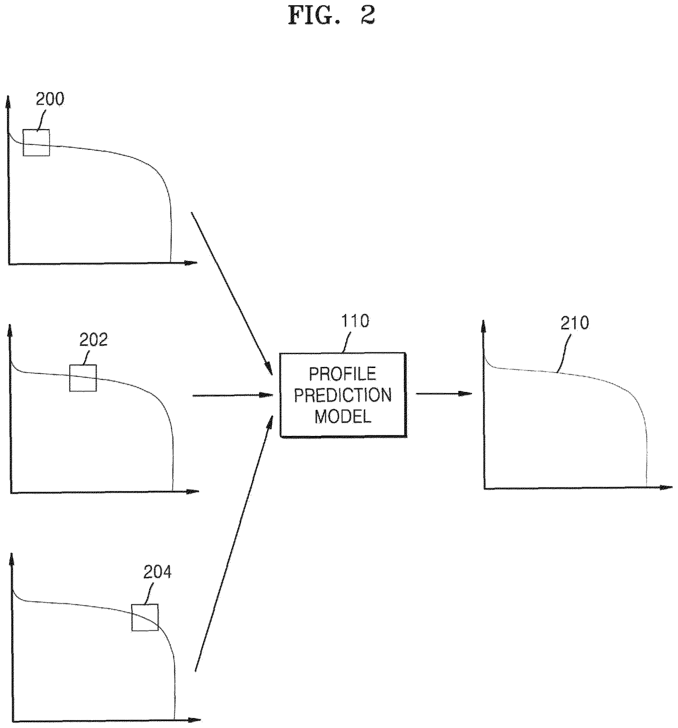

Both the profile prediction model 110 and the state prediction model 120 are artificial intelligence models generated using machine learning, deep learning, etc. More specifically, as shown in FIG. 2, the profile prediction model 110 is an artificial intelligence model that predicts and outputs a voltage profile when it receives some voltage waveforms. The profile prediction model 110 is further described with reference to FIG. 2.

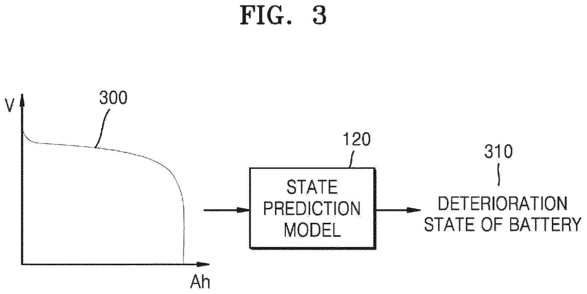

The state prediction model 120 is an artificial intelligence model that receives a voltage profile as input and predicts and outputs a deterioration state of the battery based on the voltage profile. The state prediction model 120 is further described with reference to FIG. 3.

FIG. 2 is a diagram illustrating an example of a profile prediction model according to an embodiment of the disclosure.

Referring to FIG. 2, the profile prediction model 110 is an artificial intelligence model trained to predict a voltage profile 210 based on voltage waveforms 200, 202, and 204 of some sections. The voltage waveforms (200, 202, 204) of some sections are a measurement of the amount of change in voltage when the battery is charging or discharging. The present embodiment shows voltage waveforms 200, 202, and 204 measured when the battery is discharged.

In order to identify the voltage waveform of the entire section when charging or discharging the battery, the battery voltage must be measured while discharging the battery after charging the battery 100%, or the battery voltage must be measured while charging the battery after fully discharging the battery. However, in this case, there is a disadvantage that it takes a considerable amount of time to measure the voltage waveform of the battery. For example, if a battery charging time is 1 hour, it takes 1 hour to obtain a voltage waveform for one battery, and if it takes 100 hours to obtain voltage waveforms for 100 batteries.

Accordingly, the present embodiment uses the profile prediction model 110 that generates a voltage waveform (i.e., voltage profile) of an entire section of a battery using only a voltage waveform of a certain section in a current state of the battery without charging or discharging the battery to 100%.

The battery measurement time to obtain the voltage waveforms 200, 202, and 204 may be set in various ways depending on the type or capacity of the battery, such as several to tens of minutes. For example, if the total time from discharge to charge or from charge to discharge is 1 hour, the voltage waveforms 200, 202, and 204 may be obtained by measuring a battery voltage for 10 minutes during charging or discharging the battery.

When measuring a voltage waveform while charging or discharging the battery in its current state, it is impossible to know which section of the voltage profile 210 corresponds to the section being measured. For example, as shown in FIG. 2, the voltage waveform 200 measured from a first battery corresponds to the front part of the voltage profile, the voltage waveform 202 measured from a second battery corresponds to the middle part of the voltage profile, and the voltage waveform 204 measured from a third battery corresponds to the last part of the voltage profile, but the measured voltage waveforms 200, 202, and 204 by themselves do not indicate which part of the voltage profile they respectively correspond to. In other words, in the present embodiment, the voltage waveforms 200, 202, and 204 are shown overlapping the voltage profile to facilitate understanding, but it is impossible to know which part in the voltage profile 210 corresponds to some section voltage waveforms 200, 202, and 204 obtained by measuring an arbitrary battery for a certain period of time.

Accordingly, in the present embodiment, the profile prediction model 110 may be trained and used by using learning data including a plurality of voltage profiles and a voltage waveform generated by extracting a part of the voltage profile. For example, the profile prediction model 110 may generate a predicted voltage profile based on the voltage waveforms 200, 202, and 204 after receiving learning data including the voltage waveforms 200, 202, and 204 and the voltage profile 210. Then, the profile prediction model 110 may be generated through a learning process that compares whether the predicted voltage profile is the same as the voltage profile 210 of ground truth. For example, in the example of FIG. 2, when all three voltage waveforms 200, 202, and 204 are measured on the same battery, but if the measurement sections are different from each other, the profile prediction model 110 may predict the same voltage profile 210.

The profile prediction model 110 may be implemented with various conventional networks, such as a convolutional neural network (CNN). In one embodiment, the generation of the voltage profile 210 is a conversion from a first domain where the voltage waveforms 200, 202, and 204 of some sections exist to a second domain where the voltage profile 210, which is the voltage waveform of the entire section, exists, thus, the profile prediction model 110 may be implemented as a domain transfer network. That is, the profile prediction model 110 may be trained using a transfer learning method. Because the domain transfer network itself is already a widely known configuration, detailed description thereof is omitted.

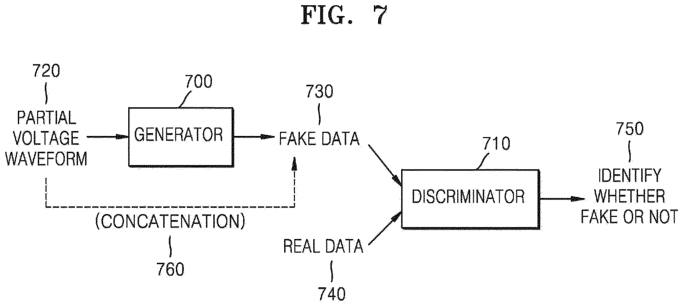

In another embodiment, because an accurate diagnosis of the deterioration state of a battery is possible only when the voltage profile 210 of a predefined section is accurately predicted based on the voltage waveforms 200, 202, and 204 of some section, thus, the profile prediction model 110 may be implemented as a generative adversarial network (GAN). The method of generating the profile prediction model 110 through the GAN is reviewed again in FIG. 7.

FIG. 3 is a diagram illustrating an example of a state prediction model 120 according to an embodiment of the disclosure.

Referring to FIG. 3, the state prediction model 120 is an artificial intelligence model trained to predict a deterioration state 310 of a battery based on the voltage profile 300. The state prediction model 120 may be generated using a supervised learning method based on learning data including voltage profiles for a plurality of batteries and the deterioration state of the batteries.

A value of the deterioration state predicted by the state prediction model 120 may be various values that indicate the deterioration state of the battery, such as charge amount (SOC, etc.) or discharge capacity, and may be implemented in various ways depending on the type of learning data of the state prediction model 120. For example, when the state prediction model 120 is trained based on learning data including a battery charge amount (e.g., a charging capacity when charged to 100%, etc.) and the voltage profile 300, the state prediction model 120 that has been trained may receive the voltage profile 300 of a certain battery, predict the amount of charge of the battery, and output the charge.

Because the state prediction model 120 predicts the deterioration state of the battery using the voltage profile 300, an accurate voltage profile 300 of the battery is needed to accurately diagnosis the deterioration state of the battery. In the present embodiment, a voltage profile is not generated by measuring a voltage of the entire section of the battery, but is generated with a voltage waveform of a partial section using the profile prediction model 110 of FIG. 2. Therefore, the time required to identify battery deterioration may be greatly reduced.

FIG. 4 is a diagram illustrating an example of a voltage profile according to an embodiment of the disclosure.

FIG. 4 shows a voltage profile according to the number of charging and discharging times of a battery. The bar graph on the right shows the number of charges and discharges of the battery. It may be seen that the voltage profile changes as the number of charging and discharging increases and the battery deteriorates.

In the present embodiment, the voltage profile is shown as a graph of a relationship between voltage V and discharging capacity Ah, but this is only one example, and the waveform of the voltage that changes when charging or discharging the battery may be measured or identified in various forms. For example, the voltage profile may be defined as a value identified not only in the form of a graph between voltage and discharge capacity in FIG. 4, but also as a relationship between voltage and various physical quantities (e.g., charging capacity, current, time, etc.). According to the embodiment, the voltage profile may be in the form of continuous values, such as a graph or in the form of discontinuous values that are periodically identified.

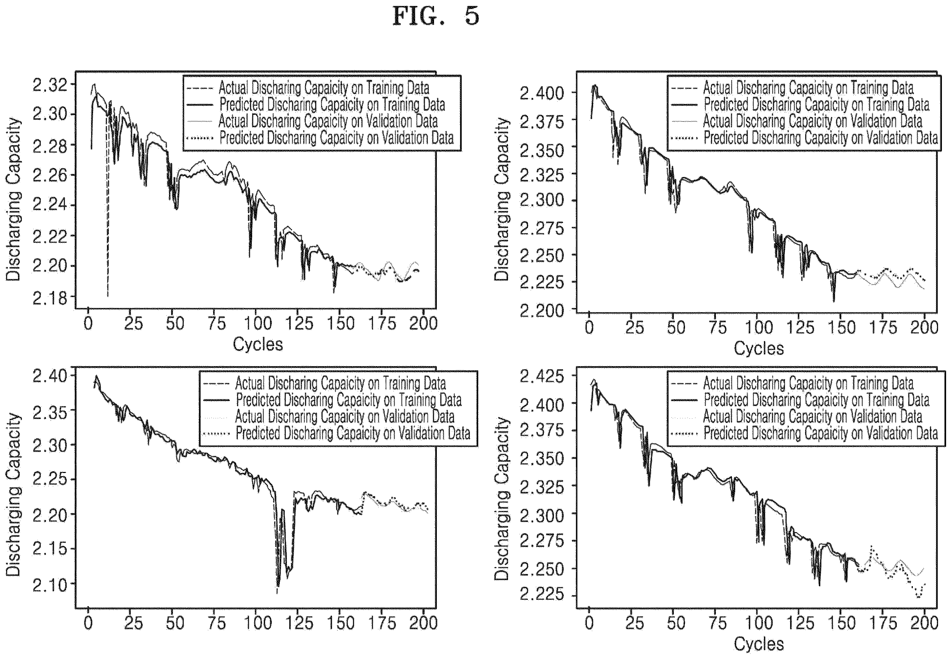

FIG. 5 is a diagram showing an experimental example of the state prediction model 120 according to an embodiment of the disclosure.

Referring to FIG. 5, results of comparing a predicted battery discharge capacity and an actual battery discharge capacity by the state prediction model 120 based on the voltage profile are shown. The horizontal axis represents the number of charging and discharging of a battery, and the vertical axis represents the battery discharge capacity according to the number of charging and discharging of the battery. Referring to the graphs, it may be seen that the predicted value of the battery discharge capacity of the state prediction model 120 and the actual battery discharge capacity are almost identical.

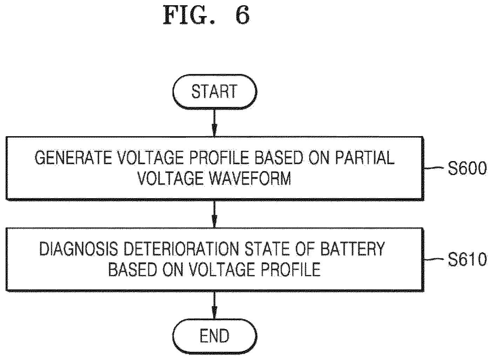

FIG. 6 is a flowchart illustrating an example of a battery diagnosis method according to an embodiment of the disclosure.

Referring to FIGS. 1 and 6 together, the battery diagnosis device 100 generates a voltage profile for a voltage waveform using the profile prediction model 110 (S600). For example, the battery diagnosis device 100 may obtain a voltage profile of a predefined section by inputting a voltage waveform of a certain section, which is obtained by actually measuring the battery for a certain period of time, into the profile prediction model 110, as shown in FIG. 2.

The battery diagnosis device 100 identifies the deterioration state of the battery by inputting the voltage profile into the state prediction model 120 (S610). An example of the state prediction model 120 is shown in FIG. 3.

FIG. 7 is a diagram illustrating an example of implementing a profile prediction model using a GAN, according to an embodiment of the disclosure.

Referring to FIG. 7, the GAN includes a generator 700 and a discriminator 710. The generator 700 is an artificial intelligence model that receives a voltage waveform 720 and predicts a voltage profile based on the voltage waveform 720. After completing learning of the GAN, the generator 700 may be used as the profile prediction model 110 according to an embodiment. The discriminator 710 receives a voltage profile (i.e., fake data 730) generated by the generator 700 and an actual voltage profile (i.e., real data 740), identifies whether the fake data 730 matches the real data 740, and outputs the identified result 750.

In the GAN, the generator 700 and the discriminator 710 learn in a competitive relationship with each other. The discriminator 710 is trained to distinguish between the real data 740 and the fake data 730, and the generator 700 is learned to generate the fake data 730 similar to the real data 740 so as to be able to fool the discriminator 710. If it is expressed as a cost function of the GAN, it will be as Equation 1 below.

## [Equation 1]

$$\min_{G} \max_{D} V(D, G) = E_{x \sim P_{data(x)}} \left[ log D(x) \right] + E_{z \sim P_z(z)} [\log(1 - D(G(z)))]$$

Here, D represents the discriminator 710 and G represents the generator 700. D(x) is a probability value (0 to 1) that the discriminator 710 discriminates the fake data 730 as the real data 740, and the closer to 1, the closer to real data. D(G(z)) is a probability value (0 to 1) indicating that the fake data 730 does not match the real data 740, and the closer to 0, the more the fake data 730 does not match the real data 740.

The discriminator (D) 710 is trained so that the right-hand term of Equation 1 above is maximized. In other words, because the discriminator (D) 710 is maximized when D(x)-1 and D(G(z))~0, the discriminator (D) 710 learns to be D(x)-1 and D(G(z))~0. Conversely, the generator (G) 700 learns so that the right-hand term of Equation 1 is minimized. That is, when the discriminator 710 identifies as D(G(z))-1, the right-hand term is minimized, thus, the generator 700 learns to be D(G(z))-1.

The battery diagnosis device 100 may train the generator 700 and discriminator 710 of a GAN using a plurality of voltage profiles and learning data including at least one voltage waveform extracted from each voltage profile. For example, the battery diagnosis device 100 inputs the voltage waveform 720 present in the learning data to the generator 700 to generate the fake data 730 including a predicted voltage profile. The real data 740 including the actual voltage profile for the voltage waveform 720 and the fake data 730 generated by the generator 700 are input to the discriminator 710, and the discriminator 710 identifies whether the fake data 730 corresponds to the form of the real data 740. The generator 700 regenerates a predicted voltage profile for the voltage waveform 720 based on the fake identifying result of the discriminator 710. That is, after regenerating a predicted voltage profile that may fool the discriminator 710, the regenerated predicted voltage profile is input to the discriminator710, and then, the generator 700 and the discriminator 710 are each learned while the discriminator 710 repeatedly performing the process of identifying whether the fake data 730 corresponds to the real data 740. Because the method itself in which the generator 700 and the discriminator 710 of a GAN learn competitively is already a known technology, detailed description thereof is omitted.

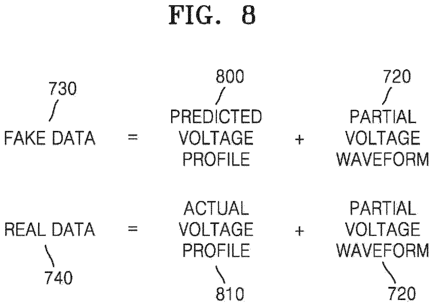

It is required that the predicted voltage profile predicted by the generator 700 not only conforms to the general voltage profile of a battery but also is a voltage profile for some voltage waveforms. For example, when the voltage waveform 720 of a certain section measured from a battery that has deteriorated significantly due to charging and discharging more than 200 times is input to the generator 700, the discriminator 710 may consider that the predicted voltage profile output by the generator 700 matches the form of voltage profile of FIG. 4 (that is, identified as matching the form of real data 740), but the predicted voltage profile generated by the generator 700 may not be a voltage profile of a battery that has significantly deteriorated after 200 or more charging cycles, and may be a voltage profile of a battery with little deterioration after 10 or more charging cycles. In this case, it is impossible to accurately diagnose the deterioration state of the battery. As a method of solving this problem, in the present embodiment, a form of the fake data 730 and the real data 740 input to the discriminator 710 is defined as a value in which a voltage profile and a voltage waveform are concatenated. An example of this is shown in FIG8.

FIG. 8 is a diagram showing an example of data input to the discriminator 710 in a GAN according to an embodiment of the disclosure.

Referring to FIGS. 7 and 8 together, the fake data 730 input to the discriminator 710 is a concatenated form of a voltage profile 800 (hereinafter, a predicted voltage profile) predicted by the generator 700 and the voltage waveform 720 input to the generator 700. That is, the fake data 730 may be expressed in the form of a vector in which a predicted voltage profile and a voltage waveform are concatenated.

The real data 740 input to the discriminator 710 includes the voltage waveform 720 used as an input to the generator 700 and an actual voltage profile 810 for the voltage waveform 720. That is, the real data 740 may be expressed in a vector form in which an actual voltage profile 810 and the voltage waveform 720 are concatenated. When traning the discriminator 710, the real data 740, in which the actual voltage profile 810 and the voltage waveform 720 are concatenated, is labeled as 1, and the fake data 730, in which the predicted voltage profile 800 and the voltage waveform 720 are concatenated, is labeled as 0. The voltage waveform 720 of the real data 740 and the fake data 730 are the same data.

Because the discriminator 710 is trained using the fake data 730 and real data 740, which include not only a voltage profile but also a voltage waveform, the discriminator 710 not only determines whether the predicted voltage profile 800 of the fake data 730 matches the voltage profile 810 of the real data as shown in FIG. 4, but also determines whether the predicted voltage profile 800 is a waveform corresponding to the voltage waveform 720. Therefore, as learning is repeated, the generator 700 not only outputs a predicted voltage profile that matches the shape of actual voltage profile as shown in FIG. 4, but also may predict a voltage profile that matches the input voltage waveform.

The final goal of GAN is as shown in Equation 2.

## [Equation 2]

$$G^* = arg \min_G \max_D L_{GAN}(G, D) + \gamma L_{const}(G)$$

## [Equation 3]

$$L_{GAN}(G, D) = E[logD(y)] + E\left[\log\left(1 - D(G(x))\right)\right]$$
$$y: total \; voltage \; profile, x: fractional \; voltage \; profile$$

## [Equation 4]

$$L_{const}(G) = E[\|y - G(x)\|_1]$$

$L_{GAN}(G,D)$ may be regarded as an objective function for a typical GAN, and $L_{const}(G)$ may be defined through a difference (L1-norm between two profiles) between a voltage profile (the predicted voltage profile 800) generated by the generator 700 and the actual voltage profile 810.. $L_{const}$ allows the generator 700 to restore the predicted voltage profile 800 similar to the actual voltage profile 810, and expresses a relative importance of $L_{GAN}$ and $L_{const}$ through a parameter $\gamma$.

More specifically, an overall cost function is denoted by G in Equation 2 and is defined as a sum of a GAN cost function $L_{GAN}(G, D)$ and a construction loss $L_{const}(G)$ expressed as a difference between the predicted voltage profile 800 and the actual target voltage profile 810. The relative importance of $L_{GAN}(G,D)$ and $L_{const}(G)$ corresponds to a hyperparameter adjusted by $\gamma$ in Equation 2. Also, G and D in Equation 2 denote weights of the generator 700 and the discriminator 710, respectively.

Equation 3 represents a specific $L_{GAN}(G, D)$. In Equation 3, x represents arbitrary information input to the generator 700, and corresponds to the voltage waveform 720 in the present embodiment. Accordingly, G(x) denotes the predicted voltage profile 800 generated by the generator 700. D(G(x)) is expressed as a probabilistic output value inferred by the discriminator 710 by receiving the predicted voltage profile 800 as input.

y denotes the actual voltage profile 810, and D(y) denotes a probabilistic output value inferred by the discriminator 710 by receiving the actual voltage profile 810. As the prediction performance of the discriminator 710 improves, the size of $L_{GAN}(G,D)$ increases, and as the generation ability of the generator 700 improves, the size of $L_{GAN}(G,D)$ decreases (when the actual data is labeled as 1 and the fake data is labeled as 0).

Accordingly, because the generator 700 is trained in a direction of lowering $L_{GAN}(G,D)$ while the discriminator 710 is trained in a direction of increasing $L_{GAN}(G,D)$, the two networks are trained in a mutually competitive environment.

Equation 4 represents the construction loss and is expressed through a difference (L1 -norm) between the predicted voltage profile 800 generated through the discriminator 710 and the actual voltage profile 810 corresponding to the voltage waveform 720. The generator 700 optimizes the weights to minimize the construction loss through learning.

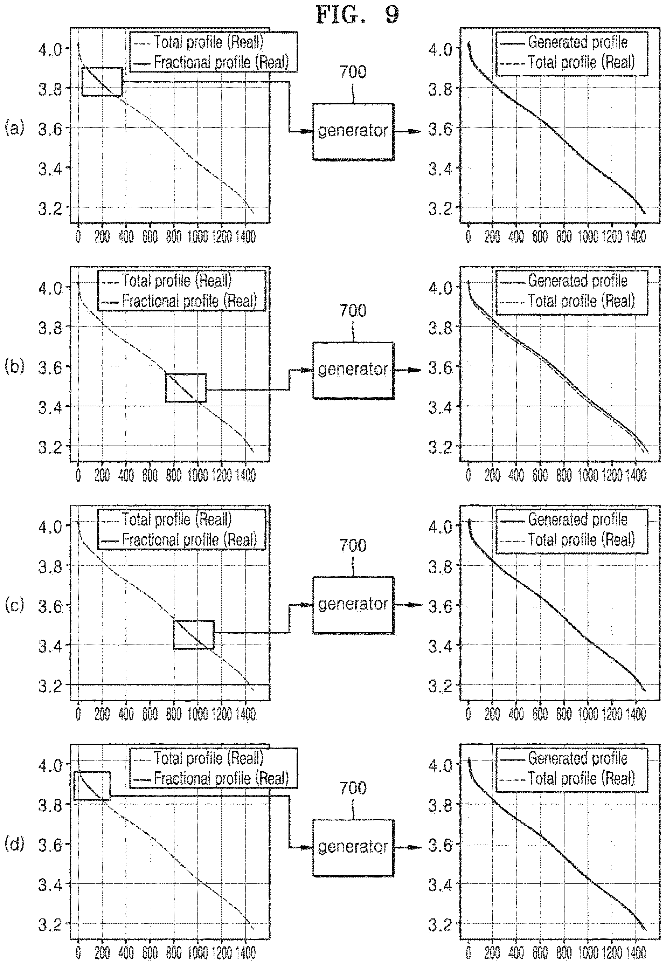

FIG. 9 is a diagram showing an example of an experiment comparing the performance of the generator 700 of a GAN according to an embodiment of the disclosure.

Referring to FIG. 9, the generator 700 that has been learned through the GAN of FIG. 7 generates a predicted voltage profile using a voltage waveform of a partial section. Referring to the graphs, it may be seen that the predicted voltage profile of the generator 700 and the actual voltage profile are almost identical.

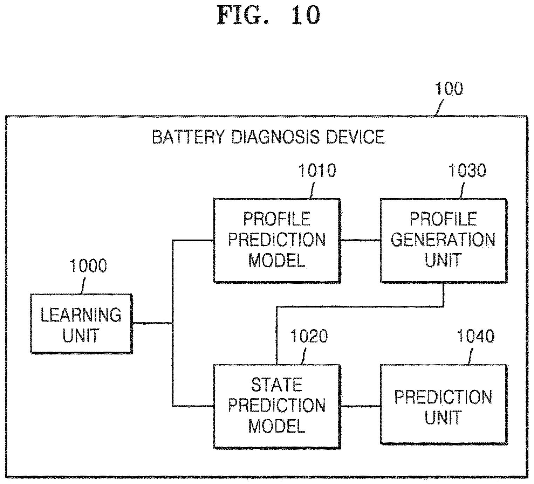

FIG. 10 is a block diagram showing the configuration of an example of a battery diagnosis device 100 according to an embodiment of the disclosure.

Referring to FIG. 10, the battery diagnosis device 100 includes a learning unit 1000, a profile prediction model 1010, a state prediction model 1020, a profile generation unit 1030, and a prediction unit 1040. As an example, the battery diagnosis device 100 may use the profile prediction model 1010 and the state prediction model 1020 that has been learned, and in this case, the learning unit 1000 may be omitted. In another embodiment, the battery diagnosis device 100 may be implemented as a computing device including a memory, a processor, and an input/output device. In this case, each component may be implemented as software, loaded on a memory, and driven by a processor.

The learning unit 1000 trains and generates the profile prediction model 1010 and the state prediction model 1020 using predefined learning data. For example, the learning unit 1000 may train and generate the profile prediction model 1010 configured of a transfer learning network. As another example, the learning unit 1000 may train the GAN of FIG. 7, which includes a generator that generates a voltage profile, and then may provide the generator learned by the GAN to the profile prediction model 1010 of the present embodiment.

The profile generation unit 1030 generates a voltage profile from a voltage waveform of a partial section using the trained profile prediction model 1010. An example of generating a voltage profile from a voltage waveform using the profile prediction model 1010 is shown in FIG. 2.

The prediction unit 1040 predicts and outputs the deterioration state of a battery from a voltage profile using the state prediction model 1020 that has been learned. The prediction unit 1040 predicts the deterioration state of a battery by receiving a voltage profile generated by the profile generation unit 1030 through the profile prediction model 1010. That is, the battery diagnosis device 100 may accurately predict the deterioration state of a battery using only the voltage waveform of a certain section of the battery.

Each embodiment of the disclosure may also be implemented as computer-readable code on a computer-readable recording medium. Non-transitory computer-readable recording media include all types of recording devices that store data that may be read by a computer system. Examples of non-transitory computer-readable recording media include ROM, RAM, CD-ROM, SSD, and optical data storage devices. Additionally, the non-transitory computer readable recording medium may also be distributed over network coupled computer systems so that the computer readable code is stored and executed in a distributed fashion.

While the disclosure has been particularly shown and described with reference to embodiments thereof. It will be understood by those of ordinary skill in the art that various changes in form and details may be made therein without departing from the spirit and scope of the disclosure. The embodiments should be considered in descriptive sense only and not for purposes of limitation. Therefore, the scope of the disclosure is defined not by the detailed description of the disclosure but by the appended claims, and all differences within the scope will be construed as being included in the disclosure.

**Claims**

1. A battery diagnosis method comprising:

   generating, by using a profile prediction model, a voltage profile of a predefined section based on a partial voltage waveform when charging or discharging a battery; and
   predicting a deterioration state of the battery based on the voltage profile by using a state prediction model,
   wherein the profile prediction model is an artificial intelligence model that learned to predict the voltage profile of a predefined section based on a partial voltage waveform, and
   the state prediction model is a state prediction model that learned to predict the deterioration state of the battery based on the voltage profile.

2. The battery diagnosis method of claim 1, wherein the profile prediction model is configured as a domain transfer network that receives a voltage waveform of a first domain and generates a voltage profile of a second domain.

3. The battery diagnosis method of claim 1, wherein the profile prediction model includes a generator of a generative adversarial network (GAN), and

the generative adversarial network includes:

the generator that outputs a predicted voltage profile upon receiving a learning voltage waveform configured as a portion of a learning voltage profile; and

a discriminator configured to compare and discriminate between fake data including the learning voltage profile and the predicted voltage profile and real data including the learning voltage profile and the learning voltage waveform.

4. The battery diagnosis method of claim 1, wherein the state prediction model is generated using a supervised learning method to predict a battery charging capacity for the voltage profile using learning data including the voltage profile and battery charging capacity.

5. A battery diagnosis device comprising:

a profile generation unit configured to generate, by using a generator of a generative adversarial network (GAN) learned to generate a voltage profile in a predefined section, a voltage profile based on a partial voltage waveform generated when charging or discharging a battery; and

a prediction unit configured to predict a deterioration state of the battery based on the voltage profile using a state prediction model that learned to predict a battery state.

6. A non-transitory computer-readable recording medium having recorded thereon a computer program for performing the battery diagnosis method described in claim 1.

FIG. 1

100

BATTERY DIAGNOSIS DEVICE

130

PARTIAL VOLTAGE
WAVEFORM OF
BATTERY

110

PROFILE
PREDICTION
MODEL

120

STATE
PREDICTION
MODEL

140

DETERIORATION STATE
STATE OF BATTERY
(SOC, ETC.)

# FIG. 2

FIG. 3

FIG. 4

# FIG. 5

EP 4 443 180 A1

# FIG. 6

START

GENERATE VOLTAGE PROFILE BASED ON PARTIAL VOLTAGE WAVEFORM —— S600

DIAGNOSIS DETERIORATION STATE OF BATTERY BASED ON VOLTAGE PROFILE —— S610

END

FIG. 7

# FIG. 8

```
        730                  800                    720
         /                    /                      /
        /                PREDICTED              PARTIAL
   FAKE DATA      =       VOLTAGE        +       VOLTAGE
                         PROFILE               WAVEFORM


                         ACTUAL                 PARTIAL
   REAL DATA      =       VOLTAGE        +       VOLTAGE
        \                PROFILE               WAVEFORM
        740                  \                      \
                            810                    720
```

# FIG. 9

# FIG. 10

100

BATTERY DIAGNOSIS DEVICE

1010

PROFILE
PREDICTION
MODEL

1030

PROFILE
GENERATION
UNIT

1000

LEARNING
UNIT

1020

STATE
PREDICTION
MODEL

1040

PREDICTION
UNIT

| INTERNATIONAL SEARCH REPORT | International application No. |
|---|---|
| | **PCT/KR2022/006616** |

**A.   CLASSIFICATION OF SUBJECT MATTER**

**G01R 31/367**(2019.01)i; **G01R 31/36**(2006.01)i; **G01R 31/3835**(2019.01)i; **G01R 31/392**(2019.01)i; **G01R 31/396**(2019.01)i; **G06N 3/08**(2006.01)i; **G06N 3/04**(2006.01)i

According to International Patent Classification (IPC) or to both national classification and IPC

**B.   FIELDS SEARCHED**

Minimum documentation searched (classification system followed by classification symbols)

G01R 31/367(2019.01); G01R 31/36(2006.01); G01R 31/382(2019.01); G16C 10/00(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 예측(prediction), 모델(model), 배터리(battery), 충전(charge), 방전(discharge), 전압프로파일(voltage profile), 열화(degradation), 인공지능(artificial intelligence)

**C.   DOCUMENTS CONSIDERED TO BE RELEVANT**

| Category* | Citation of document, with indication, where appropriate, of the relevant passages | Relevant to claim No. |
|---|---|---|
| X<br>Y | KR 10-2021-0041511 A (SAMSUNG SDI CO., LTD. et al.) 15 April 2021 (2021-04-15)<br>    See paragraphs [0008]-[0101] and claims 1 and 3. | 1,2,6<br>3-5 |
| Y | NAAZ, Falak et al. A generative adversarial network-based synthetic data augmentation technique for battery condition evaluation. International Journal of Energy Research. vol. 45, no. 13, 14 July 2021, pp. 19120-19135 [Retrieved on 11 August 2022]. Retrieved from <Wiley Online Library, https://onlinelibrary.wiley.com/doi/full/10.1002/er.7013 >.<br>    See pages 19120-19122. | 3-5 |
| A | KR 10-2020-0119383 A (SOGANG UNIVERSITY RESEARCH FOUNDATION) 20 October 2020 (2020-10-20)<br>    See entire document. | 1-6 |
| A | KR 10-2016-0067510 A (SAMSUNG ELECTRONICS CO., LTD.) 14 June 2016 (2016-06-14)<br>    See entire document. | 1-6 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **29 August 2022** | **29 August 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**

| | International application No. |
|---|---|
| | **PCT/KR2022/006616** |

| C. | DOCUMENTS CONSIDERED TO BE RELEVANT | |
|---|---|---|
| Category* | Citation of document, with indication, where appropriate, of the relevant passages | Relevant to claim No. |
| A | KR 10-2015-0049860 A (HYUNDAI MOBIS CO., LTD.) 08 May 2015 (2015-05-08)<br>See entire document. | 1-6 |

Form PCT/ISA/210 (second sheet) (July 2019)

EP 4 443 180 A1

**INTERNATIONAL SEARCH REPORT**
Information on patent family members

International application No.

**PCT/KR2022/006616**

| Patent document cited in search report | | | Publication date (day/month/year) | Patent family member(s) | | | Publication date (day/month/year) |
|---|---|---|---|---|---|---|---|
| KR | 10-2021-0041511 | A | 15 April 2021 | US | 2021-0132151 | A1 | 06 May 2021 |
| KR | 10-2020-0119383 | A | 20 October 2020 | KR | 10-2354112 | B1 | 24 January 2022 |
| KR | 10-2016-0067510 | A | 14 June 2016 | KR | 10-2343967 | B1 | 28 December 2021 |
| | | | | US | 10101406 | B2 | 16 October 2018 |
| | | | | US | 2016-0161567 | A1 | 09 June 2016 |
| KR | 10-2015-0049860 | A | 08 May 2015 | CN | 104598714 | A | 06 May 2015 |
| | | | | CN | 104598714 | B | 09 March 2018 |
| | | | | KR | 10-2177723 | B1 | 11 November 2020 |

Form PCT/ISA/210 (patent family annex) (July 2019)